# EUROPÄISCHE PATENTSCHRIFT

(11) **EP 1 118 260 B1**
(45) Veröffentlichungstag und Bekanntmachung des Hinweises auf die Patenterteilung: **05.03.2003**
(21) Anmeldenummer: 99955656.6
(22) Anmeldetag: 03.09.1999
(51) Int. Cl.: H05K 13/04

(54) **VERFAHREN UND VORRICHTUNG ZUM ZUFÜHREN VON GEGURTETEN BAUELEMENTEN**
METHOD AND DEVICE FOR FEEDING TAPED COMPONENTS
PROCEDE ET DISPOSITIF D'ALIMENTATION DE COMPOSANTS SUR BANDE

(30) Priorität: 29.09.1998 DE 19844662
(43) Veröffentlichungstag der Anmeldung: 25.07.2001
(73) Patentinhaber: Siemens Production and Logistics Systems AG, 90475 Nürnberg (DE)
(72) Erfinder: GRASMÜLLER, Hans-Horst, D-82291 Mammendorf (DE); STANZL, Harald, D-81476 München (DE)
(74) Vertreter: Berg, Peter, Dipl.-Ing.
(86) Internationale Anmeldenummer: DE9902802
(87) Internationale Veröffentlichungsnummer: WO00019797

(56) Entgegenhaltungen:
- EP-A- 0 817 560
- US-A- 4 995 157

## Beschreibung

Die Erfindung bezieht sich auf ein Verfahren und eine Vorrichtung zum Zuführen von gegurteten Bauelementen gemäß dem Oberbegriff des Anspruchs 1 bzw. des Anspruchs 4.

Bei der automatischen Bestückung von Leiterplatten mit oberflächenmontierbaren Bauelementen, den sogenannten SMD-Bauelementen, erfolgt die Bereitstellung in Form von gegurteten Bauelementen. Die Anlieferform im Gurt ist besonders automatisierungsfreundlich, da die Bauelemente bereits vereinzelt sind, und die Verpackung im Gurt weitgehende Sicherheit gegen Vertauschung gewährleistet. In den einzelnen Zuführeinrichtungen für gegurtete Bauelemente werden die Gurte mit den Bauelementen von einer Gurtspule abgespult und dann einer Entnahmeposition für die Bauelemente zugeführt. In dieser Entnahmeposition werden die Bauelemente dann mit der Saugpipette eines Bestückkopfes aufgenommen und sodann in einer vorgegebenen Bestückposition auf einer Leiterplatte positioniert. Die Abdeckfolien der Gurte, die ein Herausfallen der Bauelemente aus den Bauelementefächern der Gurte verhindern, werden noch vor Erreichen der Entnahmeposition abgezogen.

Aus EP 0 589 276 ist eine Zuführeinrichtung für gegurtete SMD-Bauelemente bekannt, die eine bewegliche Abdeckung der Bauelementefächer im Entnahmebereich aufweist. Diese Abdekkung wird synchron mit dem Gurt in Abwickelrichtung des Gurtes bewegt, bis das vorderste Bauelementefach die Entnahmeposition erreicht hat. Danach wird die Abdeckung zu Freigabe des vordersten Bauelementefaches in der Gegenrichtung bewegt. Durch die bewegliche Abdeckung werden die SMD-Bauelemente im Entnahmebereich eines Gurtes während des Transports abgedeckt, das heißt, ein Aufstellen der Bauelemente oder ein Herausspringen aus den Bauelementefachern wird verhindert.

Aus EP 0 817 560 ist ebenfalls eine Zuführeinrichtung für gegurtete SMD-Bauelemente bekannt, die eine bewegliche Abdekkung der Bauelementefächer im Entnahmebereich aufweist. Die Abdeckung ist dabei als flache Stahlfeder ausgebildet und wird durch nicht näher beschriebene Antriebsmittel so bewegt, daß kurz vor dem Entnehmen der Bauelemente das betreffende Bauelementefach freigegeben wird.

Besonders bei kleinen Bauelementen macht es sich nachteilig bemerkbar, daß die Bauelemente kleiner als die sie aufnehmenden Bauelementefächer ausgebildet sind. Normalerweise erwartet die Saugpipette in der Entnahmeposition das Bauelement in der Mitte des Bauelementefaches. Bei großen Bauelementen (mit einer Fläche von ca. 1 mm² sind Lageungenauigkeiten der Bauelemente in den Bauelementefächern unkritisch, da die aufnehmende Fläche der Saugpipette im allgemeinen kleiner als das Bauelement ausgebildet ist und daher zumindest näherungsweise in der Mitte der Oberfläche des Bauelements aufsetzt. Bei kleinen Bauelementen (Fläche kleiner als ungefähr 1 mm²) ist die aufnehmende Fläche der Saugpipetten teilweise größer als die Bauelemente selbst. Dieser sogenannte Pipettenüberstand begrenzt dann die Packungsdichte auf dem zu bestückenden Substrat. Man spricht vom "Bestückschatten". Bei kleineren Bauelementen, deren tatsächliche Lage im Bauelementefach von der erwarteten Lage in der Mitte des Bauelementefaches abweicht, kann es dann vorkommen, daß die Bauelemente nicht richtig aufgenommen werden, und es so unter anderem zu Zeitverlusten durch das Aufnehmen neuer Bauelemente oder auch zu Beschädigungen führen, falls ein falsch aufgenommenes Bauelement beim Transport von der Saugpipette in den Bestückautomaten fällt.

Aus DE 36 07 242 ist ein Verfahren zum Positionieren von Bauelementen in Vertiefungen einer Aufnahmevorrichtung bekannt, bei dem mittels einer separaten Saugpipette die Bauelemente vor dem eigentlichen Aufsetzprozeß zusätzlich angesaugt und in den Vertiefungen in eine vorgegebene Lage gebracht werden. Ein solches Verfahren ist aufgrund der zusätzlichen Saugpipette konstruktiv aufwendig und benötigt außerdem zu viel Zeit.

Aus JP 0 815 3989 ist eine Zuführeinrichtung für gegurtete Bauelemente bekannt, die eine Vibrationseinrichtung zum Antrieb der Vorschubeinrichtungen aufweist. Über die Position der Bauelemente in der Zuführeinrichtung ist keine Aussage gemacht.

Es ist daher Aufgabe der Erfindung ein Verfahren und eine Vorrichtung anzugeben, die ein sicheres Abholen von kleinen Bauelementen in Gurten sicherstellt.

Die Aufgabe wird erfindungsgemäß durch ein Verfahren und eine Vorrichtung der eingangs genannten Art mit den kennzeichnenden Merkmalen der Ansprüche 1 oder 4 gelöst.

In vorteilhafter Weise weist dafür die bewegliche Abdeckung Mittel auf, mit denen das Bauelement in eine vorgegebene genau bestimmte Lage, beispielsweise eine Ecke der Bauelementetasche, bewegt wird.

In den bevorzugten Ausgestaltungen nach den Ansprüchen 2 und 5 wird die Bewegung der Abdeckung selbst benutzt, um das Bauelement in die vorgegebene Lage zu bewegen. Dadurch entfallen aufwendige zusätzliche Konstruktionen.

Zur Verringerung der Reibung der Bauelemente in den Bauelementefächern und damit einer einfacheren Bewegung wird in vorteilhafter Weise gemäß Anspruch 3 das Bauelement mit einer Vibrationsbewegung beaufschlagt.

In der bevorzugten Ausgestaltung der Vorrichtung gemäß Anspruch 6 wird eine der Abdeckung zugeordnete Bürste verwendet, um das Bauelement in die vorgegebene Lage zu schieben. Eine Bürste ist einfach an der Abdeckung anzubringen.

Eine weitere vorteilhafte Ausgestaltung wird gemäß Anspruch 7 ein Saugrohr benutzt, um das Bauelement durch Ansaugen von Luft oder auch durch Blasen in eine vorgegebene Lage zu bewegen. Dadurch läßt sich das Bauelement gegebenenfalls auch ohne die Bewegung der Abdeckung in die vorgegebene Lage bringen.

In der bevorzugten Ausbildung nach Anspruch 8 ist eine Vibrationseinrichtung vorgesehen, damit die Reibung des Bauelements im Bauelementefach verringert und damit die Bewegung erleichtert wird.

In den Figuren der Zeichnung wird die Erfindungs anhand von zwei Ausführungsbeispielen näher erläutert.

Dabei zeigen
Figur 1 einen schematischen Querschnitt durch einen Bauelementegurt mit geschlossener Abdeckung mit einer Bürste,
Figur 2 einen schematischen Querschnitt durch einen Bauelementegurt mit freier Entnahmeposition und einer Abdeckung mit einer Bürste,
Figur 3 einen schematischen Querschnitt durch einen Bauelementegurt mit einem Saugrohr in der Abdeckung
Figur 4a eine schematische Draufsicht auf ein beliebig in einem Bauelementfach liegenden Bauelement
Figur 4b eine schematische Draufsicht auf ein Bauelement in einer vorgegebenen Lage im Bauelementfach.

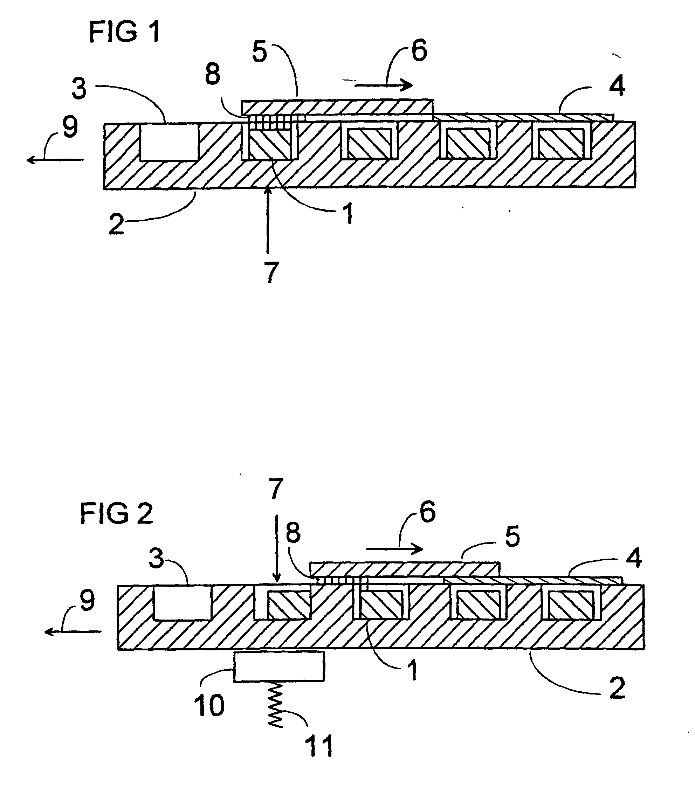

In Figur 1 sind in einem Querschnitt mehrere Bauelemente 1 in einem Bauelementegurt 2 dargestellt, wobei die Bauelemente 1 in auf deren Maße abgestimmte Bauelementfächern 3 liegen. Die Bauelementfächer 3 sind von einer Abdeckfolie 4 abgeschlossen, die vor der Entnahmeposition 7 von dem in einer Transportrichtung 9 bewegten Gurt durch eine nicht dargestellte Einrichtung abgezogen wird. Damit die Bauelemente 1 nicht aus den Bauelementefächern 3 hinaus fallen oder sich im Bauelementfach 3 verkanten, ist im Bereich der Entnahmeposition 7 eine bewegliche Abdeckung 5 vorgesehen, die vor dem Entnehmen des Bauelements 1 mit der nicht dargestellten Saugpipette des Bestückautomaten, in eine Bewegungsrichtung 6 bewegt wird und damit das Bauelementefach 3 in der Entnahmeposition 7 freigibt, wie es in Figur 2 dargestellt ist.

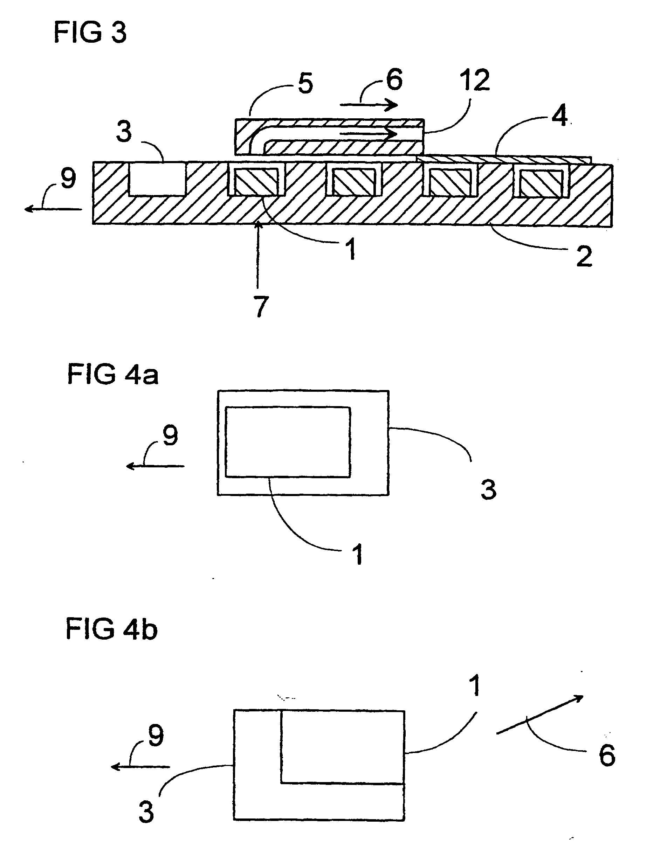

Wie in Figur 4 in einer schematischen Draufsicht dargestellt ist, sind die Abmessungen der Bauelementfächer 3 größer als die Abmessungen der Bauelemente 1. Die Bauelemente 1 liegen frei beweglich in den Bauelementefächern 3. Vor allem bei kleinen Bauelementen (Fläche kleiner als ungefähr 1 mm², oder eine Kantenlänge kleiner als ungefähr 0,5 mm) ergeben sich daraus Schwierigkeiten beim Abholen der Bauelemente 1, wenn die Lage der Bauelemente 1 in dem Bauelementfach 3 nicht bekannt ist. Als klein sind auch Bauelemente 1 anzusehen, die eine Lagetoleranz größer als 20 % ihrer Kantenlänge in dem Bauelementfach 3 aufweisen, da ihre Lage dann ungenau ist. Die Saugpipette fährt eine vorgegebene Position an, wenn sich das Bauelement 1 nicht an dieser vorgegebenen Position befindet, wird es entweder gar nicht oder so schlecht aufgenommen, daß es beispielsweise beim weiteren Transport fallengelassen wird und eventuell sogar zu einem Maschinenschaden führt.

Durch eine in Figur 1 dargestellte Bürste 8 an der Abdeckung 5 wird das Bauelement 1 in die in Figur 2 gezeigte vorgegebene Lage am Rand des Bauelementefaches bewegt. Die vorgegebene Lage kann dabei der in Bezug auf die Transportrichtung 9 hintere Rand des Bauelementfaches 3 als auch beispielsweise eine der in Bezug auf die Transportrichtung 9 hinteren Ecken des Bauelementfaches 3 sein, wie es in Figur 4b dargestellt ist. In den Ecken wird das Bauelement 1 durch zwei im wesentlichen zueinander senkrecht stehenden Kanten des Bauelementefachs 2 in der vorgegebenen Lage gehalten, wodurch die vorgegebene Lage genauer definiert ist. Die dafür nötige Bewegungsrichtung 6 läßt sich beispielsweise durch eine entsprechende Bewegungsrichtung 6 der Abdeckung 5 mit einem dafür vorgesehen Bürstenstrich realisieren.

Zur Verringerung der Reibung des Bauelementes 1 in den Bauelementefächern 3 ist in Figur 2 eine Vibrationseinrichtung 11 (beispielsweise ein Piezoschwinger) vorgesehen, die über ein Widerlager 10 für die Lagerung des Bauelementegurtes 2 den Bauelementegurt 2 in Vibrationen versetzt. Dadurch lassen sich die Bauelemente 1 einfacher an die hintere Kante des Bauelementefaches 3 bewegen.

In Figur 3 ist eine weitere Ausführungsform im Querschnitt dargestellt, in der ein Saugrohr 12 in der Abdeckung 5 angeordnet ist. Durch das Saugrohr wird Luft eingezogen und die Luftströmung zieht das Bauelement 1 je nach Lage des Saugrohrs an die hintere Kante oder in eine der hinteren Ecken des Bauelementefachs 3. Auch aus dem Rohr ausströmende Luft durch dann an den gegenüberliegenden Seiten der Abdeckung 5 angeordnete Löcher läßt sich das Bauelement 1 aufgrund der Luftströmung in die vorgegebene Lage bewegen. In dieser Ausführungsform muß die Abdeckung 5 nicht bewegt werden, um das Bauelement 1 in die vorgegebene Lage zu bringen, allerdings ist auch eine Ausführung mit Luftströmung bei gleichzeitiger Bewegung der Abdeckung 5 möglich.

## Patentansprüche

1. Verfahren zum Zuführen von gegurteten Bauelementen (1), bei dem
die Bauelemente (1) in Bauelementefächern (3) eines Gurtes (2) zu einer Entnahmeposition (7) transportiert werden,
die Bauelemente (1) mit Hilfe einer Abdeckung (5), die der Entnahmeposition (7) zugeordnet ist, in den Bauelementefächern (3) gehalten werden,
die Abdeckung (5) das Bauelementefach (3) in der Entnahmeposition freigibt,
**dadurch gekennzeichnet,**
**daß** durch der Abdeckung (5) zugeordnete Mittel das Bauelement (1) in eine vorgegebene Lage in dem Bauelementefach (3) bewegt wird.

2. Verfahren zum Zuführen von gegurteten Bauelementen (1) nach Anspruch 1,
**dadurch gekennzeichnet,**
**daß** beim Bewegen der Abdeckung (5) in der Entnahmeposition (7) das Bauelement in eine vorgegebene Lage in dem Bauelementefach (3) bewegt wird.

3. Verfahren zum Zuführen von gegurteten Bauelementen (1) nach Anspruch einem der Ansprüche 1 oder 2,
**dadurch gekennzeichnet,**
**daß** dem Bauelement (1) zur Unterstützung der Bewegung in die vorgegebene Lage eine Vibrationsbewegung beaufschlagt wird.

4. Vorrichtung zum Zuführen von gegurteten Bauelementen (1) mit einer beweglichen Abdeckung (5) von Bauelementefächern (3) eines Gurtes (2), die einer Entnahmeposition (7) zugeordnet ist,
**dadurch gekennzeichnet,**
**daß** die Abdeckung (5) Mittel (8,12) zur Bewegung des Bauelements (1) in eine vorgegebene Lage in dem Bauelementefach (2) aufweist.

5. Vorrichtung zum Zuführen von gegurteten Bauelementen (1) nach Anspruch 4,
**dadurch gekennzeichnet,**
**daß** die Mittel (8,12) derartig gestaltet sind, daß das Bauelement (1) beim Bewegen der Abdeckung (5) in der Entnahmeposition (7) in die vorgegebene Lage bewegt wird.

6. Vorrichtung zum Zuführen von gegurteten Bauelementen (1) nach Anspruch 5,
**dadurch gekennzeichnet,**
**daß** die Mittel als Bürste (8) ausgebildet sind, die das Bauelement (1) in die vorgegebene Lage schiebt.

7. Vorrichtung zum Zuführen von gegurteten Bauelementen (1) nach einem der Ansprüche 4 oder 5,
**dadurch gekennzeichnet,**
**daß** die Mittel als Saugrohr (12) ausgebildet sind, das durch die Bildung eines Unterdrucks im Saugrohr (12) das Bauelement (1) in die vorgegebene Lage bewegt.

8. Vorrichtung zum Zuführen von gegurteten Bauelementen (1) nach einem der Ansprüche 4 bis 7,
**dadurch gekennzeichnet,**
**daß** eine Vibrationseinrichtung (11) vorgesehen ist, die das Bewegen des Bauelements (1) in die vorgegebene Lage unterstützt.

## Claims

1. Method of feeding taped components (1), in which
the components (1) are transported in component compartments (3) of a tape (2) to a removal position (7),
the components (1) are held in the component compartments (3) with the aid of a cover (5) which is assigned to the removal position (7),
the cover (5) opens the component compartment (3) in the removal position,
**characterized in that**
the component (1) is moved into a predefined position in the component compartment (3) by means associated with the cover (5).

2. Method of feeding taped components (1) according to Claim 1,
**characterized in that**
during the movement of the cover (5) in the removal position (7), the component is moved into a predefined position in the component compartment (3).

3. Method of feeding taped components (1) according to either of Claims 1 and 2,
**characterized in that**
in order to assist the movement into the predefined position, the component (1) is acted on by a vibrational movement.

4. Apparatus for feeding taped components (1), having a movable cover (5) for component compartments (3) of a tape (2), the cover (5) being associated with a removal position (7),
**characterized in that**
the cover (5) has means (8, 12) for moving the component (1) into a predefined position in the component compartment (2).

5. Apparatus for feeding taped components (1) according to Claim 4,
**characterized in that**
the means (8, 12) are configured in such a way that, during the movement of the cover (5) in the removal position (7), the component (1) is moved into the predefined position.

6. Apparatus for feeding taped components (1) according to Claim 5,
**characterized in that**
the means are formed as a brush (8), which shifts the component (1) into the predefined position.

7. Apparatus for feeding taped components (1) according to either of Claims 4 and 5,
**characterized in that**
the means are formed as a suction pipe (12), which moves the component (1) into the predefined position as the result of the formation of a vacuum in the suction pipe (12).

8. Apparatus for feeding taped components (1) according to one of Claims 4 to 7,
**characterized in that**
a vibration device (11) is provided which assists the movement of the component (1) into the predefined position.

## Revendications

1. Procédé destiné à approcher des composants (1) sur bandes
dans lequel
les composants (1) sont transportés vers une position d'extraction (7) dans des cases à composants (3) d'une bande (2),
les composants (1) sont maintenus dans les cases à composants (3) à l'aide d'une couverture (5), qui est affectée à la position d'extraction (7),
la couverture (5) ouvre la case à composants (3) à la position d'extraction,
**caractérisé par le fait**
**que**, grâce à des moyens affectés à la couverture (5), le composant (1) est déplacé, dans la case à composants (3), vers une position prédéterminée.

2. Procédé destiné à approcher des composants (1) sur bandes
selon la revendication 1
**caractérisé par le fait**
**que**, lors du déplacement de la couverture (5) à la position d'extraction (7), le composant est déplacé vers une position prédéterminée dans la case à composants (3).

3. Procédé destiné à approcher des composants (1) sur bandes
selon l'une des revendications 1 ou 2
**caractérisé par le fait**
**qu'**un mouvement de vibration est appliqué au composant (1) pour aider son déplacement vers la position prédéterminée.

4. Dispositif destiné à approcher des composants (1) sur bandes, ayant une couverture amovible (5) des cases à composants (3) d'une bande (2), couverture qui est affectée à une position d'extraction (7),
**caractérisé par le fait**
**que** la couverture (5) comporte des moyens (8, 12) destinés à déplacer le composant (1) vers une position prédéterminée dans la case à composants (2).

5. Dispositif destiné à approcher des composants (1) sur bandes
selon la revendication 4
**caractérisé par le fait**
**que** les moyens (8, 12) sont conçus de telle sorte que le composant (1) est déplacé vers la position prédéterminée par le déplacement de la couverture (5) à la position d'extraction (7).

6. Dispositif destiné à approcher des composants (1) sur bandes
selon la revendication 5
**caractérisé par le fait**
**que** les moyens sont conçus sous la forme d'une brosse (8), qui fait glisser le composant (1) vers la position prédéterminée.

7. Dispositif destiné à approcher des composants (1) sur bandes
selon l'une des revendications 4 ou 5
**caractérisé par le fait**
**que** les moyens sont conçus sous la forme d'un tube d'aspiration (12), qui déplace le composant (1) vers la position prédéterminée par formation d'une dépression dans le tube d'aspiration (12).

8. Dispositif destiné à approcher des composants (1) sur bandes
selon l'une des revendications 4 à 7
**caractérisé par le fait**
**qu'**il est prévu un dispositif vibratoire (11), qui supporte le déplacement du composant (1) vers la position prédéterminée.
